## Europäisches Patentamt
## European Patent Office
## Office européen des brevets

(19)

(11) Publication number: **0 098 661**
**B1**

(12) **EUROPEAN PATENT SPECIFICATION**

(45) Date of publication of patent specification: **13.09.89**

(51) Int. Cl.⁴: **H 03 H 9/64**

(21) Application number: **83200986.4**

(22) Date of filing: **04.07.83**

(54) Acoustic surface wave device including a reflective multistrip coupler.

(30) Priority: **05.07.82 GB 8219372**
**05.07.82 GB 8219373**

(43) Date of publication of application:
**18.01.84 Bulletin 84/03**

(45) Publication of the grant of the patent:
**13.09.89 Bulletin 89/37**

(84) Designated Contracting States:
**DE FR GB**

(56) References cited:
**EP-A-0 103 932**
**FR-A-2 398 412**
**GB-A-1 492 766**

(73) Proprietor: **PHILIPS ELECTRONIC AND ASSOCIATED INDUSTRIES LIMITED**
**Philips House 188 Tottenham Court Road London W1P 9LE (GB)**
(84) **GB**

(73) Proprietor: **N.V. Philips' Gloeilampenfabrieken**
**Groenewoudseweg 1**
**NL-5621 BA Eindhoven (NL)**
(84) **DE FR**

(72) Inventor: **Schofield, John**
**C/O MULLARD LIMITED New Road Mitcham Surrey CR4 4XY (GB)**
Inventor: **Flinn, Ian**
**C/O PHILIPS RESEARCH LABORATORIES Redhill Surrey RH1 5HA (GB)**
Inventor: **Murray, Robert John**
**C/O PHILIPS RESEARCH LABORATORIES Redhill Surrey RH1 5HA (GB)**

(74) Representative: **Stevens, Brian Thomas et al PHILIPS ELECTRONICS Patents and Trade Marks Department Centre Point New Oxford Street London WC1A 1QJ (GB)**

Courier Press, Leamington Spa, England.

## Description

This invention relates to an acoustic surface wave device comprising a piezoelectric substrate for propagating an acoustic surface wave at a surface thereof, transducer means for launching acoustic surface wave energy so as to propagate over said surface and for converting acoustic surface wave energy propagating over said surface into an electrical signal, and electrical coupling means for receiving acoustic surface wave energy propagating along a first propagation track and relaunching at least part of that energy as acoustic surface wave energy into a second propagation track, said electrical coupling means comprising a first array of electrically conductive strips across said first track and a second array of electrically conductive strips across said second track, each array including discrete parallel electrically conductive strips each of which is electrically insulated from the other said discrete conductive strips of that array and is electrically connected to a respective said discrete conductive strip of the other array in such a manner that the successive said discrete conductive strips of each array are electrically connected to the successive said discrete conductive strips of the other array, the centre-to-centre spacings of the successive said discrete conductive strips of each array being alternately relatively large and relatively small, and the electrical connections between that said discrte conductive strips of the two arrays being such that, in each array, the said discrete conductive strips of each pair which have a said relatively large centre-to-centre spacing are connected to the respective strips of a pair in the other array which have a said relatively small centre-to-centre spacing. Such an acoustic surface wave device will be referred to herein as an acoustic surface wave device of the kind specified.

One form of a device of this kind is disclosed in U.K. Patent Specification GB—A—1,492,766 which relates to a coupler for a surface acoustic wave device for introducing or removing dispersion from a signal by reflecting signal components of different frequencies at different points along a surface acoustic save delay line so that the reflected signals travel along a different path or track from the applied signals.

The process of track-changing is also employed in other surface acoustic wave devices, such as band-pass filters, in order to reduce the transfer of energy from the launching to the receiving transducer *via* the various bulk acoustic wave modes also lauched by the type of interdigital transducers normally employed, and such devices commonly employ a form of multistrip coupler, for example as disclosed in U.K. Patent Specification GB—A—1,372,235. This form of coupler, when suitably proportioned, can transfer acoustic surface wave energy relatively efficiently to a second track in the same direction as that of the incident wave launched along the first track. However, a filter device using such an arrangement will occupy a considerable area on the surface of a piezoelectric crystal wafer making the device expensive to manufacture. This is especially significant in the case of relatively narrow band filter devices for use in frequency multiplex applications, such as for example in telephony, in which the attainment of a narrow band-width necessitates the use of relatively long arrays to provide the required selectivity.

Clearly, a more compact and therefore less expensive acoustic surface wave filter device could be manufactured if a reflective multistrip coupler could be provided having a sufficiently low insertion loss while providing a significant filtering effect.

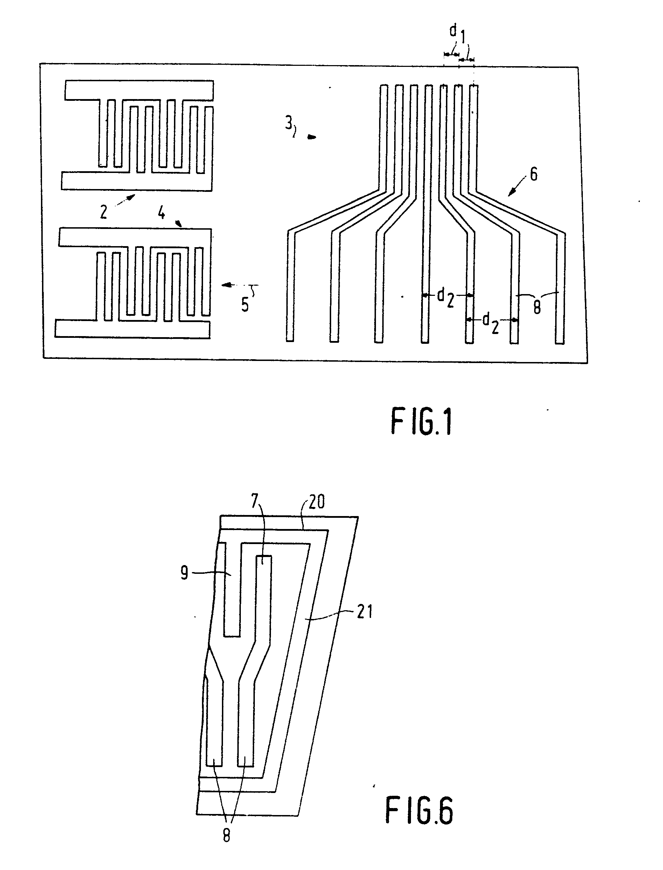

A device including one form of reflective multistrip coupler, which may be used, for example, as a filter for a electrical signal applied to the transducer means is known from a paper by M. Feldmann and J. Henaff entitled "A new multistrip acoustic surface waver filter" printed in the Proceedings of the IEEE Ultransonics Synposium 1974 at pages 157—160. One simple such device is shown in diagrammatic form in Figure 1 of the accompanying drawings and comprises a piezoelectric substrate 1 for propagating an acoustic surface wave at a surface thereof, transducer means comprising an input transducer 2 for launching acoustic surface wave energy into a first propagation track (denoted by an arrow 3) at said surface and an output transducer 4 for converting acoustic surface wave energy propagating along a second track (denoted by a arrow 5) into an electrical signal, and electrical coupling means 6 for receiving acoustic surface wave energy propagating along the first track 3 and relaunching at least part of that energy as acoustic surface wave energy into the second track 5. The input and output transducers are both of the interdigital type, the electrical input signal being applied between the two sets of electrodes of the transducer 2 and the electrical output signal being taken off from across the two sets of electrodes of the transducer 4. The electrical coupling means 6 comprises a first array of electrically conductive strips across the first track 3 and a second array of electrically conductive strips across the second track 5. The first array comprises N discrete parallel electrically conductive strips 7 whch are electrically insulated from each other and the second array comprises N discrete parallel electrically conductive strips 8 which are electrically insulated from each other. Each of the strips 7 is electrically connected to a respective one of the strips 8 in such manner that the successive strips of each array are connected to the successive strips of the other array. The strips 7 have equal centre-to-centre spacings $d_1$ and the strips 8 have equal centre-to-centre spacings $d_2$, where $d_1$ and $d_2$ are mutally different and satisfy the condition $d_1 + d_2 = n\lambda$, where $n$ is an integer (e.g. unity) and $\lambda$ is the wavelength of an acoustic surface wave launched into the track 3 by the input transducer 2 or lying within a band of wavelengths of acoustic surface waves launched into the track 3 by the input transducer 2. (The centre-to-centre spacings of the strips making up the input and output transducers may be, for example $\lambda/4$ in the customary double-electrode configuration). As is known from the IEEE Symposium paper quoted above, because $d_1+d_2=n\lambda$ the multistrip coupler 6 is reflective for acoustic surface waves of wavelength $\lambda$, i.e. acoustic surface waves of wavelength $\lambda$ launched towards one end of the array of strips 7 by the transducer 2 will be relaunched (in practice in attenuated form) from the corresponding end of the array of strips 8. $d_1$ is chosen to be different from $d_2$ because, if both were equal to $\lambda/2$, the condition $d_1-d_2=m\lambda$, where $m$ is an integer or zero, would also be satisfied and, as is known from another paper by M. Feldmann and J. Henaff entitled "Design of Multistrip Arrays" printed in the Proceedings of the IEEE Ultrasonics Symposium 1977 at pages 686—690, this is the condition for the multistrip coupler 6 to be transmissive for acoustic waves of wavelength $\lambda$, so that a large proportion of the available acoustic wave energy would emerge from the right-hand side of the array of strips 8 and hence would not find its way to the output transducer 4.

The operational properties of the coupler 6 which are normally relevant in the device shown, in particular the bandwidth of its response and its insertion loss, are determined, inter alia, by the number N of strips 7 and 8 in the two arrays, these two quantities decreasing as the number N is increased. One disadvantage of the coupler 6 shown is that, if large values of the number N are required, as would be the case in order to provide an acceptably low insertion loss, and for a relatively narrow band filter, the electrical connections between the outer strips 7 and the corresponding strips 8 become very long. As these connections form a capacitive (and resistive) load this results in an increase in the insertion loss. Moreover the space between the array of strips 7 and the array of strips 8 occupied by these connections must then be kept quite broad, which results (a) in even the electrical connections between the inner strips 7 and 8 being appreciably longer than they would otherwise be, and hence in a further increase in the insertion loss, and (b) in waste of part of the potentially useful surface area of the substrate 1.

To overcome these problems a coupling arrangement such as that shown in said Patent GB—A—1,492,766 could be considered, however, the arrangements shown in Figures 2 and 4 of that patent would be too expensive to manufacture because of the need for insulated cross-over connections, and the other arrangements shown in Figures 3 and 5 of that patent would in practice be unsatisfactory because of significantly higher insertion loss and poor frequency response.

It is an object of the invention to provide an improved acoustic surface wave device of the kind specified.

The invention provides an acoustic surface wave device of the kind specified, characterised in that each array includes a plurality of further electrically conductive strips which are parallel to the said discrete conductive strips of that array, in that at least one of said further strips is or are situated between the respective discrete conductive strips forming substantially every pair having a said relatively large centre-to-centre spacing, and in that all said further electrically conductive strips in both said arrays are electrically interconnected.

The invention is based on the realisation that although the electrode arrays in a device of the kind specified could be rendered more uniform to the passage of acoustic surface waves along each track by interspersing one or more individual dummy electrodes within the gap between each relatively widely spaced pair of said discrete conductive strips in each array, an additional, significant and unexpected improvement both in frequency discrimination and in the reduction of insertion loss can result from providing a common electrical interconnection to the interspersed (dummy) electrodes in both arrays so that they no longer merely serve the function of dummy electrodes but seem to have the effect of performing a signal-reinforcing function along the whole extent of the array at frequency whose wavelength coincides with the periodicity of the relatively large centre-to-centre spacings along each array.

The result of this common electrical interconnection has been found, surprisingly, to be capable of reducing the insertion loss and of improving the frequency discrimination of a reflective multistrip coupler of a device of the kind specified because of the effect of a corresponding transfer of signal currents throughout the array *via* the common interconnection.

Preferably at least one of the further electrically conductive strips is situated between the discrete conductive strips of each pair having a relatively large centre-to-centre spacings. It is also preferable that all the relatively large centre-to-centre spacings should be substantially equal to one another, and that all the relatively small centre-to-centre spacings should similarly be equal to one another. In order to provide the maximum effect of signal transfer along the whole of both arrays and hence an optimal amount of frequency discrimation and low insertion loss for a given length of array the relatively large centre-to-centre spacings should have a periodicity of $\lambda_0$ along each array, where $\lambda_0$ is the acoustic surface wavelength at the mid-band frequency $f_0$ of the device.

In one embodiment of the invention a single further strip is located between the discrete conductive strips of each pair having the relatively large centre-to-centre spacing.

As mentioned previously, the condition for reflection is $d_1+d_2=\lambda n$ and in one example of the embodiment, $d_1=\lambda/3$ and $d_2=2\lambda/3$, i.e., in each array the centre-to-centre spacing of the said discrete conductive strips of each pair which have a said relatively large centre spacing is approximately twice the centre-to-centre spacing of the strips in the other array to which the strips of this pair are connected.

In a further embodiment, two further strips are located between the discrete conductive strips of each pair having the relatively large centre-to-centre spacing, and in one example of that embodiment $d_1=\lambda/4$ and $d_2=3\lambda/4$.

It may or may not be desirable in a particular case that the sums of the spacings of each two pairs of interconnected strips should be the same, i.e. correspond to the same value of $\lambda$. It may be, for example, that these sums should be arranged to steadily increase on going from one end of each array to the other, i.e. to correspond to steadily increasing values of $\lambda$, in order to obtain a required frequency response of the device.

it will be apparent that the presence of the strips will affect the surface properties of the piezoelectric substrate as seen by an acoustic surface wave travelling at it surface, it is therefore preferable that, in each array, the discrete conductive strips and the further strips should be uniformaly spaced along the array and should present a constant mark-to-space ratio and surface loading in respect of applied conductive material.

It should be noted that the common interconnection can either be connected to a steady potential, such as ground, and this may be preferable for some applications, or it can remain unconnected so as to float electrically in a manner similar to the remainder of the array electrodes. A slight difference in the frequency response may be found as between these alternative arrangements. However, both can provide a reduction in insertion loss and a more compact reflective multistrip coupler than the prior art devices.

Embodiments of the invention will now be described by way of example, with reference to the accompanying diagrammatic drawings, in which:-

Figure 1 shows a known device already discussed,

Figure 2 shows a first embodiment of the invention,

Figure 3 shows a second embodiment of the invention,

Figure 4 shows a practical example of the first embodiment,

Figure 5 shows a practical example of the second embodiment, and

Figure 6 shows an alternative form of interconnecting arrangement for use in Fgures 4 or 5.

Corresponding components are denoted by the same reference numerals in the various Figures.

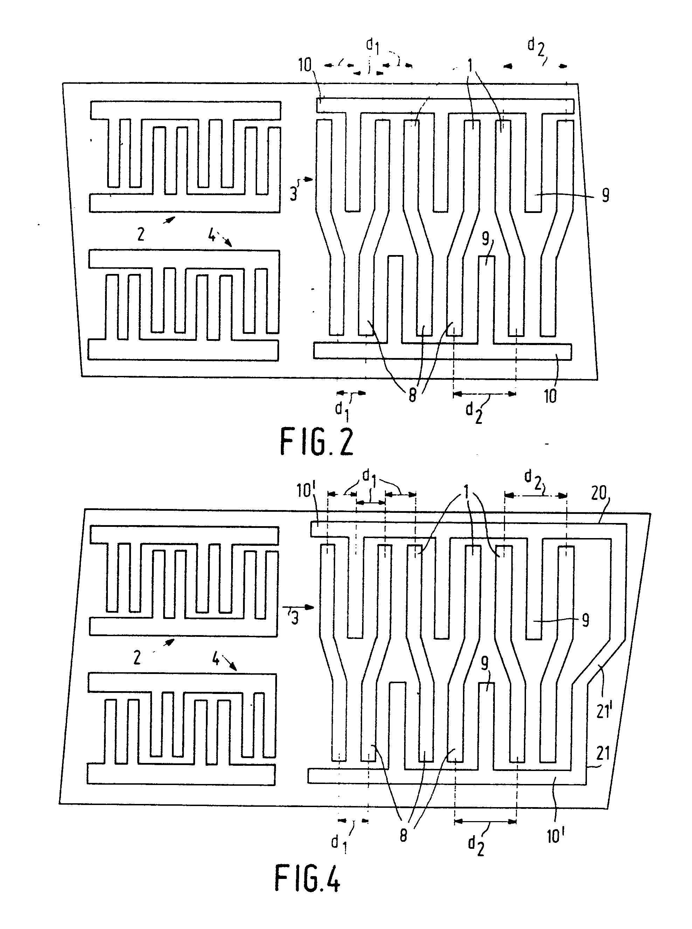

In Figure 2 an acoustic surface wave device comprises, similarly to the device of Figure 1, a piezoelectric substrate 1 for propagating an acoustic surface wave at a surface thereof, transducer means comprising an input transducer 2 for lauching acoustic surface wave energy into a first propagation track (denoted by an arrow 3) at said surface and an output tranducer 4 for converting acoustic wave energy propagating along a second track (denoted by an arrow 5) into an electrical signal, and electrical coupling means 6 for receiving acoustic surface wave energy propagating along the first track 3 and relaunching at least part of that energy as acoustic surface wave energy into the second track 5. Again the electrical coupling means 6 comprises a first array of electrically conductive strips across the first track 3 and a second array of electrically conductive strips across the second track 5. The first array again comprises N discrete parallel electrically conductive strips 7 which are electrically insulated from each other and the second array again comprises N discrete parallel electrically conductive strips 8 which are electrically insulated from each other. Again each of the strips 7 is electrically connected to a respective one of the strips 8 so that the successive said strips of each array are connected to the successive strips of the other array. However, now the centre-to-centre spacings of the strips 7 alternate between $d_1$ and $d_2$, so do the centre-to-centre spacings of the strips 8, $d_1$ and $d_2$ again being mutually different. In fact $d_2=2$ $d_1$ in the device shown in Figure 2, and $d_1$ and $d_2$ satisfy the condition $d_1+d_2=n\lambda$, where $n$ is an integer (e.g. unity) and $\lambda=\lambda_o$ where $\lambda_o$ is the wavelength at the mid-frequency $f_o$ of the passband of the device, or $\lambda$ can be a wavelength lying within a band of wavelengths of acoustic surface waves launched into the tracks 3 by the input transducter 2 in operation. The electrical connections between the strips 7 and 8 are such that, in each array, each pair of strips which have a centre-to-centre spacing of $d_2$ are connected to the respective strips of a pair in the other array which have a centre-to-centre spacing $d_1$. The device of Figure 2 operates in a similar manner to that of Figure 1, a portion of the acoustic surface wave energy of wavelength approximately $\lambda$ incident on the array of strips 7 covering track 3 being relaunched into track 5 by the array of strips 8, but the total length of the coupling means 6 in the direction of the track 3 is, in the device of Figure 2, significantly less than the corresponding length of the coupling means 6 in Figure 1.

It should be understood that, for the sake of clarity in representation, the drawings only show each array as being made up of a small number N of strips. In practice this would cause the insertion loss to be too great on the substrate materials normally used. In order to provide an acceptably low insertion loss for a commercially useful device N would have to be much larger, for example 150 to 200 for 128°-cut or Y-cut lithium niobate, although it may be possible to use as few as 20 to 30 strips on the high-coupling 41°-rotated cut of lithium niobate. It will therefore be apparent that in a practical case in which N can range from 20 to 200, the coupling means 6 of the device of Figure 2 will be very much shorter than the coupling means 6 of Figure 1, resulting in less waste of the available surface area of the substrate, and in a smaller device.

Moreover, in contradistinction to the coupler 6 of Figure 1, in the coupler 6 of Figure 2 all the electrical connections between strips 7 and the strips 8 are of the same length however many strips 7 and 8 are provided, and this length is certainly no more than, and for large numbers of strips considerably less than, the minimum corresponding length in the coupler of Figure 1, which can be of advantage as regards simplicity of manufacture and in the interests of reducing the insertion loss of the coupler 6. So far the device is similar to the reflective coupler shown in Figure 5 of U.K Patent Specificaion GB—A—1,492,766.

In accordance with the invention at least one further electrically conducting strip is situated between the respective strips 7 or 8 forming substantially every pair having a relatively wide centre-to-centre spacing $d_2$. These further strips are electrically interconnected, and can if desired be connected to a point of constant potential, for example ground. The presence of a single such further strip between each pair of strips 7 or 8 which have the large spacing $d_2$ will give the desired result when $d_2=2d_1$, as shown in the embodiment of Figure 2, and such a further electrically conductive strip 9 is provided between and parallel to each pair of strips 7 and 8 which have the larger centre-to-centre spacing $d_2$ in such manner that the centre-to-centre spacing between each further strip and each of the strips 7, 8 adjacent thereto is equal to $d_2/2$. This configuration allows the piezoelectric substrate 1 to appear as homogenous as possible to the acoustic surface wave propagating in the track 3, 5 under the arrays of strips. The further strips 9 preferably have the same widths as the strips 7 and 8, which widths may be equal to $d_1/2$ in order to give a "mark-to-space" ratio of unity on going along each array. The strips of each of the two resulting sets of further strips 9 are electrically interconnected by means of an auxiliary strip conductor 10 extending perpendicularly thereto in the manner shown, and the auxiliary strips are furthermore interconnected, for example in that they are connected to a constant potential point (not shown), for example ground.

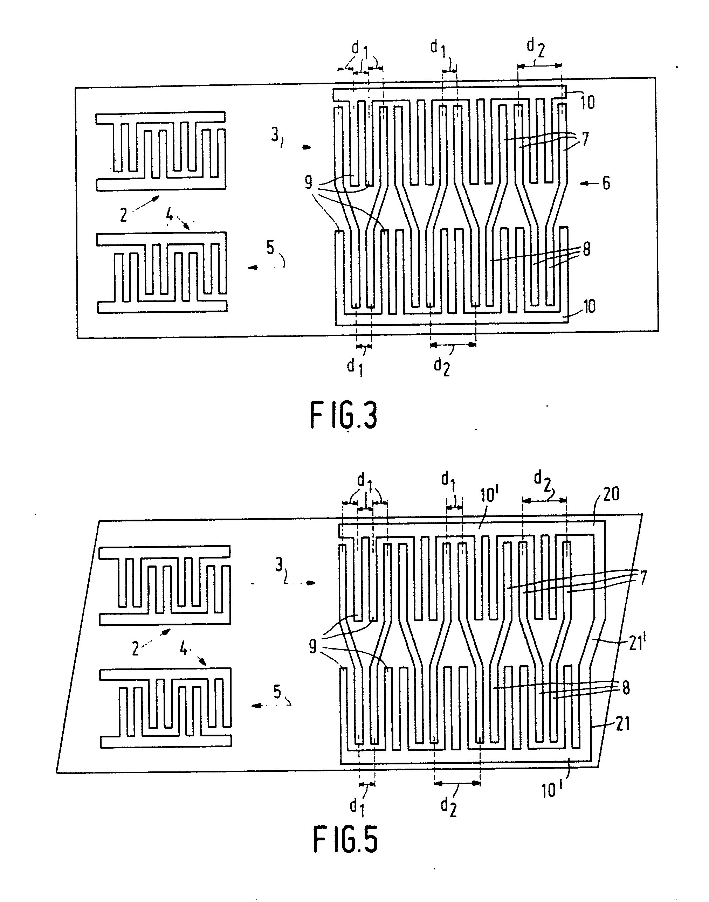

A second embodiment of the invention is shown in Figure 3. In this embodiment two further electrically conducting strips 9 are situated between the discrete conductive strips 7 or 8 respectively which form each pair having the relatively large centre-to-centre spacing $d_2$, and the desired result will be obtained when $d_2=3d_1$. As in Figure 2, the further strips 9 are interconnected by strip conductors 10 respectively disposed along the other edge of the corresponding array parallel to the acoustic surface wave propagation direction along the array.

Figure 4 shows a practical example of the first embodiment of Figure 2 in which the electrical interconnection of the further electrically conductive strips 9 in both arrays is provided by a common electrical conductor 20 in the form of respective strip-like portions 10' disposed along the other edge of a corresponding array and arranged parallel to the acoustic surface wave propagation direction along the array, and a linking electrically conducting strip-like portion 21 disposed across an end of the electrical coupling means 6. The strip-like portion 21 should not disturb the transducing relationship between the surface waves progagating in each of the arrays, and the potential on the further strips 9 to which is is connected, and this condition is satisfied in Figure 4 by causing the conductor 21 to occupy the position that the next further strip 9 would have occupied at the end of the respective array if it had been present, and also to comprise a central connecting portion 21' between the surface wave tracks.

Figure 5 illustrates a similar practical example of the embodiment of Figure 3.

Figure 6 is a detail illustrating an alternative form for the linking conductor portion 21 in which the strip is inclinded at an angle to strips 7, 8 and 9, so that it will not be coherent with the wavefront of a desired surface wave propagating in either array and therefore transduction or reflection thereby of undesired surface wave components will be substantially prevented with respect to the surface wave propagation track direction through the respective arrays.

It will be appreciated that the devices of Figures 2, 3, 4 and 5 are only examples of many possible embodiments of the invention. For example the number of interdigitated electrodes in the input and/or output transducers 2 and 4 may be differnt to that shown, as may be the number of strips 7 and 8 included in each array making up the coupling means 6. As another example the construction of the input and ouput tranducers 2 and 4 may be different to that shown and may be apodised in convention manner in order to provide a diesired pass-band response. The ratio of $d_2$ to $d_1$ may be different from two as shown in Figure 2 and 4 or from three as shown in Figures 3 and 5 (with, possibly, a corresponding change in the number of further electrodes 9 (if present) provided between each pair of relatively widely spaced electrodes 7 or 8) and may even be different for different interconnected pairs of relatively widely spaced strips 7 or 8 in one array and relatively narrowly spaced strips 8 or 7 in the other array. Thus, for example, the successive strips 7 may have centre-to-centre spacings of $\lambda/4$, $19\lambda/20$, $\lambda/20$ and $3\lambda/4$ repeating, in which case the corresponding centre-to-centre spacings of the strips 8 may be $3\lambda/4$, $\lambda/20$, $19\lambda/20$ and $\lambda/4$ repeating. Usually, however, the sum of the centre-to-centre spacing of each adjacent pair of strips 7 or 8 in one array and the centre-to-centre spacing of the pair of strips 8 or 7 in the other array to which these strips are connected will be substantially the same (preferably equal to $\lambda$) for all such interconnection pairs, although in particular applications it may be that even these sums vary, preferably in a smooth manner, along the length of the coupler 6. Even if the ratio of $d_2$ to $d_1$ is nominally two as in Figures 2 and 4, it need not be exactly so. It may for example be within the range 1.50 to 2.70 or within the range 1.70 to 2.34, there being only a gradual deterioration in performance as the preferred value of two is departed from. Similarly, if the ratio of $d_2$ to $d_1$ is nominally three, it may for example be within the range 2.34 to 4.00 or within the range 2.70 to 3.35 with similar effect.

The strips 7 and 8 may be apodized in known manner, if desired, though this can only in general be carried out if the corresponding transducer 2, 4, is not apodized.

Although the strips 7 and the interspersed strips 9 are shown parallel to the strips 8 and the interspersed strips 9 making the tracks 3 and 5 parallel to each other this is not essential; the mutually parallel strips 8 and their interspersed strips 9 may be at an angle to the mutually parallel strips 7 and their interspersed strips 9 if desired, in which case the tracks 3 and 5 will no longer be mutually parallel. It should be noted in the case of Figures 2 and 4 that because the conductors 7 and 9, or 8 and 9, are spaced centre-to-cenre by, nominally, one third of a wavelength at the centre frequency of the pass-band, the reflective multistrip coupler 6 will tend to reject the third harmonic of that frequency.

The acoustic surface wave propagation path from the input transducer 2 to the output transducer 4 may be arranged to encounter more than one coupler 6 if desired so that, for example, the path comprises more than two mutually parallel tracks. As another example two couplers 6 may be provided on the substrate 1 in such manner that the input track 3 of each is constituted by the output track portion 5 of the other, in which case a single combined input/output transducer may be situated at some point one the resulting closed complete path, thereby forming a resonator.

It should be understood, that while Figures 2, 3, 4 and 5 illustrate examples in accordance with the invention, in which at least one further strip 9 is situated between each pair of strips 7 or 8 which have a relatively wide centre-to-centre spacing, the advantages of the invention can nevertheless be provided when the further strips are not present in some, namely at most about 20%, of the relatively wide centre-to-centre spacings of either array, and this may sometimes be desired in order to modify the transfer response of the reflective coupler.

In a practical version of a device similar to that shown in Figure 3 the piezoelectric substrate 1 was composed of 41°Y-rotated X-propagating lithium niobate on which aluminium was vacuum-deposited to a depth of approximately 0.2 μm and subjected to a photo-lithographic process to form the electrical conductors constituting the input and output transducers 2 and 4 and the reflecting multistrip coupler 6. The number of strips 7 was eight, as was the number of strips 8 and the number of (grounded) strips 9 in each array. The widths of the strips 7, 8 and 9 were each 15.2 μm, as were the widths of the gaps between adjacent ones of these strips. Each of the strips 7, 8 and 9 was 2.43 mm long. The separation between the array of strips 7, 9 and the array of strips 8, 9 was 0.52 mm. Each transducer 2 and 4 was of a double-finger structure and included eight interdigitated strips each 15.2 μm wide and 2.432 mm long and with a centre-to-centre spacing between adjacent strips (each constituting a finger) of 30.4 μm. The input signal applied to input tranducer 2 was within a frequency band centred on 37 MHz, the latter frequency corresponding to a wavelength of the resulting surface acoustic waves in the substrate 1 of approximately 121.6 μm. As compared with a similar device in which the configuration of the coupling means 6 was as shown in Figure 1 this device exhibited approximately 1 dB less insertion loss and approximately 15% greater bandwidth between nulls.

While reference is made herein to reflective multistrip couplers being relatively narrow bandwidth devices and therefore particularly suitable for filtering frequency multiplex communication channels, the band width achieved will depend on the length of the arrays in the coupler and the use of a high coupling piezoelectric substrate, such as lithium niobate, can enable an array to be manufactured which can be entirely satisfactory for use in television filtering applications especially those in which the fractional bandwidth can be kept small, for example in cable television, satellite television receivers and community antenna apparatus.

## Claims

1. An acoustic surface wave device comprising a piezoelectric substrate for propagating an acoustic surface wave at a surface thereof, transducer means for launching acoustic surface wave energy so as to propagate over said surface and for converting acoustic surface wave energy propagating over said surface into an electrical signal, and electrical coupling means for receiving acoustic surface wave energy propagating along a first propagating track and relaunching at least part of that energy as acoustic surface wave energy into a second propagation track, said electrical coupling means comprising a first array of electrically conductive strips across said first track and a second array of electrically conductive strips across said second track, each array including discrete parallel electrically conductive strips each of which is electrically insulated from the other said discrete conductive strips of that array and is electrically connected to a respective said discrete conductive strip of the other array in such a manner that the successive said discrete conductive strips of each array are electrically connected to the successive said discrete conductive strips of the other array, the centre-to-centre spacings of the successive said discrete conductive strips of each array being alternately relatively large and relatively small, and the electrical connections between the said discrete conductive strips of the two arrays being such that, in each array, the said discrete conductive strips of each pair which have a said relatively large cnetre-to-centre spacing are connected to the respective strips of a pair in the other array which have a said relatively small centre-to-centre spacing, characterised in that each array includes a plurality of further electrically conductive strips which are parallel to the sid discrete conductive strips of the array, in that at least one of said further strips is or are situated betwen the respective discrete conductive strips forming substantially every pair having a said relatively large centre-to centre spacing, and in that all said further electrically conductive strips in both said arrays are electrically inconnected.

2. A device as claimed in Claim 1, characterised in that at least one of said further electrically conductive strips is situated between the discrete conductive strips of each pair having a relatively large centre-to-centre spacing.

3. A device as claimed in Claim 1 or Claim 2, characterised in that said interconnected further electrically conductive strips are connected to a constant potential point.

4. A device as claimed in any one of the preceding claims, characterised in that all the said relatively large centre-to-centre spacings are substantially equal to each other, as are all the said relatively small centre-to-centre spacings.

5. A device as claimed in any one of the preceding claims, characterized in that said relatively large centre-to-centre spacings have a periodicity of $\lambda_o$ along each array, where $\lambda_o$ is the acoustic surface wavelength at the mid-band frequency $f_o$ of the device.

6. A device as claimed in any one of the preceding claims characterised in that in each said array said discrete conductive strips and said further strips are substantially uniformly spaced along the array.

7. A device as claimed in Claim 6, characterised in that a single said further strip is located between the discrete conductive strips of each pair having a said relatively large centre-to centre spacing.

8. A device as claimed in Claim 6, characterised in that two said further strips are located between the discrete conductive strips of each pair having a said relatively large centre-to-centre spacing.

9. A device as claimed in any one of the preceding claims, characterised in that the electrical interconnection of said further electrically conductive strips comprises a common electrical conductor in the form of respective strip-like portions disposed along the outer edge of a corresponding array parallel to the acoustic surface wave propagation direction along that array, and a linking electrically conducting strip-like portion disposed across an end of said electrical coupling means and arranged so that substantially no undesired surface acoustic wave signal is transduced thereby in the propagation direction along either array.

**Patentansprüche**

1. Akustische Oberflächenwellen-Anordnung mit einem piezoelektrischen Substrat zum Fortpflanzen einer akustischen Oberflächenwelle auf einer Oberfläche desselben, mit einer Wandlereinheit zum Liefern akustischer Oberflächenwellenenergie zum Fortpflanzen über diese Oberfläche und zum Umsetzen akustischer, sich über diese Oberfläche fortpflanzender Oberflächenwellenenergie in ein elektrisches Signal, und mit einem elektrischen Koppler zum Empfangen akustischer, sich entlang einer ersten Fortpflanzungsspur fortpflanzender Oberflächenwellenenergie und zum erneuten Liefern wenigstens eines Teils dieser Energie als akustischer Oberflächenwellenenergie in eine zweite Fortflanzungsspur, wobei der elektrische Koppler eine erste Reihe elektrisch leitender, sich quer zur ersten Spur erstreckender Streifen une eine zweite Reihe elektrisch leitende, sich quer zur zweiten Spur erstreckender Streifen enthält, wobei jede Reihe diskrete, parallel verlaufende, elektrisch leitende Streifen enthält, die je von den anderen diskreten leitenden Streifen dieser Reiher elektrisch isoliert und mit je einem diskreten leitenden Streifen der anderen Reiher derart elektrisch verbunden sind, daß die aufeinanderfolgenden diskreten leitenden Streifen jeder Reihe mit den aufeinanderfolgenden diskreten leitenden Streifen jeder Reihe mit den aufeinanderfolgenden diskreten leitenden Streifen der anderen Reihe elektrisch verbunden sind, wobei die Abstände von Mitte zu Mitte der aufeinanderfolgenden diskreten leitenden Streifen jeder Reihe abwechselnd verhältnismäßig groß und verhältnismäßig klein sind, und die elektrischen Verbindungen zwischen den diskreten leitenden streifen der beiden Reihen derart ausgeführt sind, daß in jeder Reihe die diskreten leitenden Streifen jedes Paares mit einem erwähnten, verhältnismäßig großen Abstand von Mitte zu mitte mit den jeweiligen Streifen eines Paares in der anderen Reihe mit einem erwähnte, verhältnismäßig kleinen Abstand von Mitte zu Mitte verbunden sind, dadurch gekennzeichnet, daß jede Reihe eine Anzahl weiter elektrisch leitende Streifen parallel zu den diskreten lietenden Streifen dieser Reihe enthält, daß wenigstens einer der weiteren Streifen sich zwischen den jeweiligen diskreten leitenden Streifen befindet, die im wesentlichen jedes Paar mit einem verhältnismäßig großen Abstand von Mitte zu Mitte bilden, und daß alle weiteren, elektrisch leitenden Streifen in den beiden Reihen elektrisch miteinander verbunden sind.

2. Anordnung nach Anspruch 1, dadurch gekennzeichnet, daß wenigstens einer der weiteren elektrisch leitenden Streifen sich zwischen den diskreten leitenden Streifen jedes Paars mit einem verhältnismäßig großen abstand von Mitte zu Mitte befindt.

3. Anordnung nach Anspruch 1 oser 2, dadurch gekennzeichnet, daß die miteinander verbundenen, wieteren elektrisch leitenden Streifen mit einem Punkt konstanten Potentials verbunden sind.

4. Anordnung nach einem oder mehreren der vorangehenden Ansprüche, dadurch gekennzeichnet, daß alle verhältnismäßig großen Abstände von Mitte zu Mitte im wesentlichen gleich sind sowie auch alle verhältnißmäßig kleinen Abstände von Mitte zum Mitte.

5. Anordnung nach einem oder mehreren der vorangehenden Ansprüche, dadurch gekennzeichnet, daß die verhältnismäßig großen Abstände von Mitte zum Mitte eine Periodenzahl von $\lambda_o$ entlang jeder Reihe haben, wobei $\lambda_o$ die akustische Oberflächenwellenlänge bei der Zwischenbandfrequenz $f_o$ der Anordnung ist.

6. Anordnung nach einem oder mehreren der vorangehenden Ansprüche, dadurch gekennzeichnet, daß in jeder Reihe die diskreten leitende Streifen und die weiteren Streifen entlang der Reihe im wesentlichen in regelmäßigen Abständen angeordnet sind.

7. Anordnung nach Anspruch 6, dadurch gekennzeichnet, daß ein einziger weiterer Streifen sich zwischen den diskreten leitenden Streifen jedes Paares mit einem verhältnismäßig großen Abstand von Mitte zu Mitte befinde.

8. Anordnung nach Anspruch 6, dadurch genennzeichnet, daß zwei weitere Streifen sich zwischen den diskreten leitenden Streifen jedes Paares mit einem Verhältnismäßig großen Abstand von Mitte zu Mitte befinden.

9. Anordnung nach einem oder mehreren der vorangehenden Ansprüche, dadurch gekennzeichnet, daß die gegenseitige elektrische Verbindung der weiteren elektrisch leitenden Streifen einen gemeinsamen elektrischen Leiter als jeweilige streifenartige Teile entlang des Außenrandes einer entsprechenden Reihe parallel zur Fortpflanzungsrichtung der akustischen Oberflächenwellen entlang dieser Reihe sowie einen elektrisch leitenden streifenartigen Verkettungsteil quer zum Ende des elektrischen Kopplers enthält, und derart angeordnet ist, daß dabei im wesentlichen kein ungewünschtes akustisches Oberflächenwellensignal in der Fortpflanzugsrichtung in einiger Reihe umgesetzt wird.

**Revendications**

1. Dispositif à ondes acoustiques de surface comportant un substrat piézo-électrique pour propager une onde acoustique de surface sur une surface de celui-ci, des moyens transducteurs pour émettre de l'énergie d'ondes acoustiques de surface de façon à la propager sur ladite surface, et pour convertir en un signal électrique l'énergie dondes acoustiques de surface se propageant sur ladite surface, et des moyens de couplage électriques pour recevoir de l'énergie d'ones acoustiques de surface se propageant le long d'une première piste de propagation et pour réémettre au moins un partie de cette énergie comme énergie d'ones acoustiques de sourface vers une deuxième piste de propagation, lesdits moyen de couplage électriques comportant un premier réseau de bandes électriquement conductrices s'étendant en travers de ladite première piste et un deuxième réseau de bandés électriquement conductrices s'étendant en travers de ladite deuxième piste, chaque réseau comportant des bandes électriquement conductrices parallèles discrètes qui sont électriquement conductrices parallèles discrètes qui sont électriquement isoléés les unes des autres et qui, chacune, sont reliés électriquement à une bande conductrice discrète correspondante de l'autre réseau, de telle manière que lesdites bandes conductrices discrètes successives de chaque réseau soient électriquement reliées auxdites bandes conductrices discrètes successives de l'autre réseau, les entraxes desdites bandes conductrices discrètes successives de chaque réseau étant alternativement relativement grands et relativement faibles, et les liaisons électriques entre lesdites bandes conductrices discrètes des deux réseaux étant telles que, dans chaque réseau, lesdites bandes conductrices discrètes de chaque paire séparées par ledit entraxe relativement grand sont reliées aux bandes correspondanes d'une paire dans l'autre réseaux séparées par ledit entraxe relativement faible, carctérisé en ce que chaque réseau comporte une pluralité d'autres bandes électriquement conductrices qui sont parallèles auxdites bandes conductrices discrètes de ce réseau, en ce qu'au moins l'une desdites autres bandes est située entre les bandes conductrices discrètes correspondantes formant sensiblement chaque paire ayant ledit entraxe relativement grand, et en ce que toutes lesdite autres bandes électriquement condcutrices dans lesdits deux réseaux sonte électriquement interconnectées.

2. Dispositif selon la revendication 1, caractérisé en ce qu'au moins l'une desdites autres bandes électriquement conductrices est située entre les bandes conductrices discrètres de chaque paire ayant un entraxe relativement grand.

3. Dispositif selon la revendication 1 ou 2, caractérisé en ce que lesdites autres bandes électriquement conductrices interconnectées sont reliées à un point de potentiel constant.

4. Dispositif selon l'une quelconque des revendications précédentes, caratérisé en ce que lesdits entraxes relativement grands sont tous sensiblement égaux les uns aux autres, tout comme lesdits entraxes relativement faibles.

5. Dispositif selon l'une quelconque des revendications prédédentes, caractérisé en ce que lesdits entraxes relativement grands ont une péridicité de $\lambda_o$ le long de chaque réseau, où $\lambda_o$ est la longuerur d'onde acoustique de surface à la fréquentce centrale de bande $f_o$ du dispositif.

6. Dispositif selon l'une quelconque des revendications précédentes, caractérisé en ce que, dand chccun desdits réseaux, lesdites bandes conductrices discrètes et lesdites autres bandes sont sensiblement unformément espacées le long du réseau.

7. Dispositif selon la revendication 6, caractérisé en ce qu'une seule desdite autres bandes est située entre les bandes conductrices discrètes de chaque paire ayant ledit entraxe relativement grand.

8. Dispositif selon la revendication 6, caractérisé en ce que deux desdites autres bandes sont situées entre les bandes conductrices discrètes de chaque paire ayant ledit entraze relativement grand.

9. Dispositif selon l'une quelconque de revendictions précédentes, caractérisé en ce que l'interconnexion électrique desdites autres bandes électriquement conductrices comporte un conducteur électrique commun réalisé sous la forme de parties en forme de bande disposées le long du bord extérieur d'un réseau correspondant, parallèlement à la direction de propagation d'ondes acoustiques de surface le long de ce réseau, et une partie de liaison en forme de bande électriquement conductrice disposée en travers d'une extrémité desdits moyens de couplage électriques et prévue de façon que pratiquement aucun signal d'onde acoustique de surface non désiré ne soit transmis par celle-ci dans la direction de propagation le long de chaque réseau.

FIG.1

FIG.6

FIG.2

FIG.4

2

FIG.3

FIG.5

3